Europäisches Patentamt

(19) European Patent Office

Office européen des brevets

(11) Numéro de publication: **0 215 707 B1**

(12) **FASCICULE DE BREVET EUROPEEN**

(45) Date de publication du fascicule du brevet:
03.10.90

(51) Int. Cl.⁵: **H03K 17/10**

(21) Numéro de dépôt: **86401956.7**

(22) Date de dépôt: **05.09.86**

(54) **Dispositif de commutation de tension.**

(30) Priorité: **06.09.85 FR 8513278**

(43) Date de publication de la demande:
**25.03.87 Bulletin 87/13**

(45) Mention de la délivrance du brevet:
**03.10.90 Bulletin 90/40**

(84) Etats contractants désignés:
**DE GB IT SE**

(56) Documents cités:
**EP-A- 0 048 758**
**DE-A- 2 431 006**
**GB-A- 2 109 184**
**US-A- 4 367 421**

(73) Titulaire: **THOMSON-CSF, 51, Esplanade du Général de Gaulle, F-92800 Puteaux(FR)**

(72) Inventeur: **Rambert, Bernard, THOMSON-CSF SCPI 19, avenue de Messine, F-75008 Paris(FR)**

(74) Mandataire: **Benoît, Monique et al, THOMSON-CSF SCPI, F-92045 PARIS LA DEFENSE CEDEX 67(FR)**

## Description

L'invention a principalement pour objet un dispositif de commutation de tension.

Le brevet EP 0 048 758 décrit un dispositif de répartition de tension aux bornes d'une pluralité de transistor MOS, sur lequel est basé le préambule de la revendication 1.

Le dispositif objet de la présente invention permet une commutation rapide de tension. Pour commuter des tensions élevées le dispositif selon l'invention utilise des transistors à effet de champ à grilles isolées appelés MOS dans la suite de ce brevet. Un transistor MOS disponible actuellement ne peut pas supporter dans détérioration des tensions supérieures à 1000 V. Pour effecteur des commutations des tensions plus importantes typiquement en 1000 et 3000 V il est primordial qu'aucun des transistors mis en série n'ait à supporter des tensions supérieures aux tensions risquant de provoquer sa détérioration.

Le dispositif objet de la présente invention répartit statiquement et dynamiquement les tensions de façon à pouvoir fonctionner sans risque de détérioration ou de destruction. L'utilisation de transistors MOS permet de limiter la consommation électrique, une fois la commutation établie.

Le dispositif objet de la présente invention est pratiquement apériodique, c'est-à-dire très peu sensible à l'état antérieur. Ainsi, le dispositif objet de la présente invention peut atteindre des hautes fréquences de commutation. Ceci permet l'application du dispositif selon l'invention à la commutation de tension sur les grilles de tubes électroniques, comme par exemple les tubes à ondes progressives (TOP) ou des klystrons. De même, la rapidité de la commutation permet de plus une haute fréquence de répétition. Par exemple pour une plage de valeur des temps de communication comprise entre 0,8 μs et 40 μs on obtient des fréquences de répétition comprise entre 0 et 50 kHz.

Le dispositif selon la présente invention présente l'avantage de ne pas exiger pour sa construction des composants triés. Ceci est permis par un équilibrage dynamique des tensions sur les divers transistors MOS mis en série.

La présente invention a principalement pour objet un élément modulaire de commutation de tension comportant une première entrée et une première sortie connectées en parallèle à travers une résistance, un condensateur, une seconde entrée reliée à la source d'un transistor à effet de champ à grille isolée de puissance, une seconde sortie reliée au drain dudit transistor, ladite première entrée étant reliée à la grille dudit transistor, caractérisé par le fait qu'il comporte une diode dont le pôle doppé positivement est relié à la première entrée et le pôle doppé négativement est relié à la première sortie.

La réalisation sera mieux comprise au moyen de la description ci-après et des figures annexées données comme des exemples non limitatifs parmi lesquels:

– la figure 1 est un schéma d'un premier exemple du dispositif selon l'invention;

– la figure 2 est un schéma de détail de réalisation du dispositif illustré sur la figure 1;

– la figure 3 est un schéma d'un détail de réalisation du dispositif illustré par la figure 1;

– la figure 4 est un schéma d'une seconde variante de réalisation du dispositif selon l'invention;

– la figure 5 est un schéma d'un détail de réalisation du dispositif illustré sur la figure 4;

– la figure 6 est un schéma d'un dispositif selon l'invention mettant en œuvre le dispositif des figures 1 à 4;

– la figure 7 est un schéma d'un détail de réalisation du dispositif illustré par la figure 6;

– les figures 8 à 16 sont les courbes illustrant la performance obtenue par le dispositif selon l'invention.

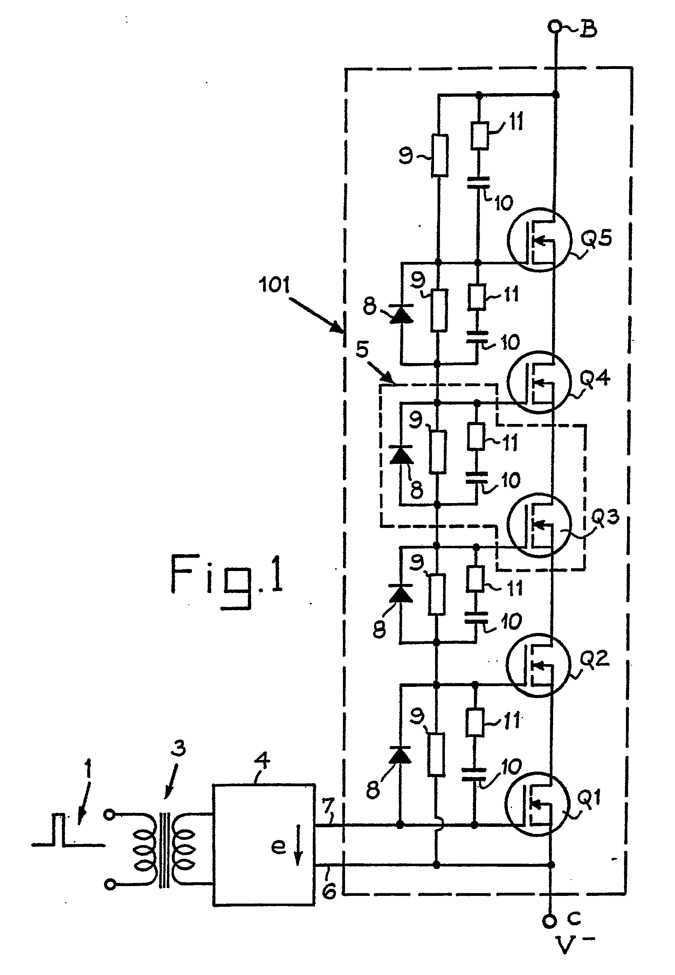

Sur les figures 1 à 16 on a utilisé les mêmes références pour désigner les mêmes éléments.

Sur la figure 1, on peut voir un exemple de réalisation d'un commutateur 101 permettant d'annuler la différence de potentiel entre deux points B et C. Ce montage présente les particularités suivantes:

- il est normalement bloqué avec possibilité de déblocage pendant des temps courts par exemple sur 10 ns et un facteur cylindrique faible ;

- il supporte une tension très faible au repos (état bloqué) mais peut supporter brusquement une tension élevée sans être rendu conducteur ;

- lorsqu'il est rendu conducteur par une impulsion de commande, il reprend naturellement son état bloqué sans impulsion de commande supplémentaire.

Le commutateur 101 est alimenté en impulsions de commande 1 par un dispositif de mémorisation 4 à travers un transformateur d'isolation 3.

Avantageusement pour conserver la forme des impulsions 1 on utilise un transformateur 3 réalisé en structure de lignes de transmission. Par exemple, on utilise pour le bobinage du transformateur 3 un câble coaxial.

Le circuit de mémorisation 4 est relié par les lignes 6 et 7 au premier étage du commutateur 101. Dans l'exemple illustré, le commutateur comporte cinq étages. La ligne 7 est reliée à la grille d'un transistor MOS Q1, à l'entrée d'une diode 8 et d'un condensateur 10. La ligne 6, est reliée à l'entrée d'une résistance 9, à la source du transistor Q1 ainsi qu'au point C porté au potentiel négatif V-. Le commutateur 101 a pour but sur un signal de commande 1 de pouvoir porter le point B au potentiel V-. Le condensateur 10, est relié à une résistance 11. Les sorties de la diode 8, des résistances 9 et 11 sont réunies et reliées aux entrées des mêmes éléments de l'étage suivant d'une part, et à la grille du transistor Q2 appartenant au second étage d'autre part. Le drain du transistor Q1 est relié à la source du transistor Q2.

Les connexions décrites ci-dessus se répètent jusqu'au dernier étage 5, cinquième dans le cas présent. Le cinquième étage ne comporte pas de diode 8. La sortie des résistances 9 et 11 ainsi que le drain du transistor Q5 sont reliés au point B.

En fonctionnement normal, le dispositif illustré sur la figure 1 comporte des ponts équilibrés des condensateurs et des résistances répartissant les tensions aux bornes des transistors Q1 à Q5 bloqués. Si un des transistors Q1 à Q5 fuit il va s'établir une différence de potentiel entre la grille et la source du transistor de l'étage suivant renforçant son blocage.

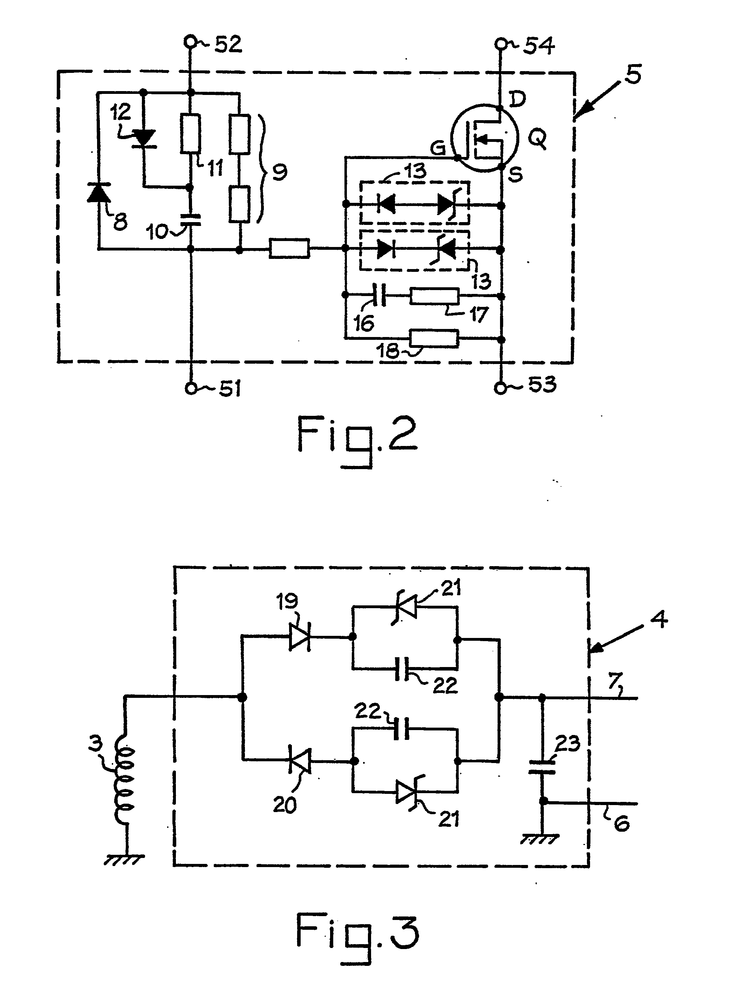

Sur la figure 2, on peut voir un exemple de réalisation d'un étage 5 optimisé du commutateur 101 de la figure 1. Une entrée 51 de l'étage 5 est reliée à une diode rapide 8, un condensateur 10 et deux résistances 9 mises en série. Le condensateur 10 est relié à la résistance 11. Les sorties des résistances 9, de la résistance 11 et de la diode 8 sont reliées à l'entrée d'une diode 12 d'une part, à la sortie 52 de l'étage 5 d'autre part. La sortie de la diode 12 est reliée à la connexion du condensateur 10 à la résistance 11. Une entrée 53 de l'étage 5 est reliée à une résistance 18, à une résistance 17, à deux transils à faible capacité 13 placées en parallèle et polarisées chacune dans un sens différent ainsi qu'à la source du transistor Q. La résistance 17 est reliée à un condensateur 16. Les sorties de la résistance 18, du condensateur 16, des deux transils 13 sont reliées à une résistance 15 d'une part et d'autre part à la grille du transistor MOS Q. La résistance 15 est reliée à l'entrée 51 de l'étage 5. Le drain du transistor Q est relié à la sortie 54 de l'étage 5. Dans un exemple de réalisation, la Demanderesse a utilisé les valeurs suivantes pour les composants d'un étage 5 :
- diodes 8 et 12 diodes rapides ;
- condensateur 10 : 470 pF ;
- résistance 9 : 2 × 150 kΩ, 0,5 W ;
- résistance 15 : 22Ω;
- résistance 18 : 10 kΩ;
- condensateur 16 : 1 nF ;
- résistance 17 : 4,7Ω les transils sont à faible capacité ;
- transistor Q : transistor MOS IRF 420.

La résistance 11 a pour but de répartir les charges injectées dans la grille des transistors Q des divers étages 5 au moment de la mise en conduction de l'ensemble. Sa valeur est variable avec les étages. Pour les valeurs des composants décrits ci-dessus un exemple de réalisation à six étages comporte une résistance 11 de 15Ω pour le second étage, de 33Ω pour le troisième étage de 68Ω pour le quatrième étage, de 150Ω pour le cinquième étage. Dans un exemple de réalisation le premier étage ne comporte pas de résistance 11.

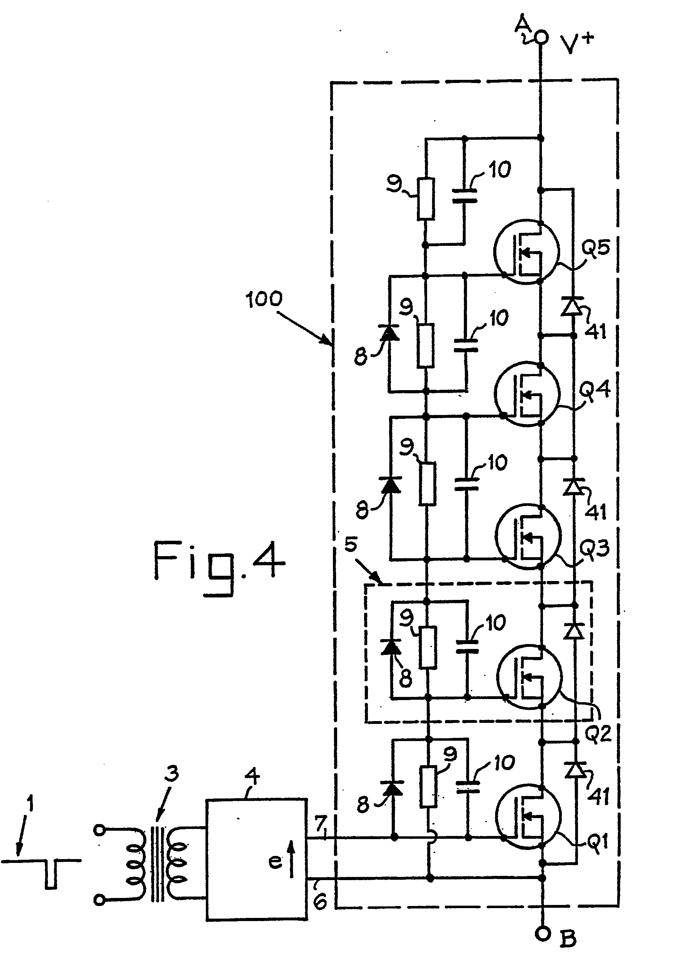

Sur la figure 3, on peut voir un exemple de réalisation du circuit de mémorisation 4 du signal électrique. L'entrée du circuit 4 est reliée au secondaire du transformateur 3. L'entrée du circuit 4 est reliée en parallèle à deux circuits à seuil comportant chacun une diode 19 mise tête-bêche avec une diode Zener 21. Les deux circuits à seuil ont des polarités inverses. Les diodes Zener étant incapables de passer des impulsions on met en parallèle avec chaque diode Zener 21 une capacité 22. La sortie des circuits à seuil est reliée d'une part à la ligne 7, d'autre part à travers un condensateur 23 à la ligne 6 et à la masse.

Lorsque sur l'entrée du circuit 4 on envoie une impulsion dont la tension est supérieure à la tension de la diode Zener 21 un courant charge le condensateur 23. Le condensateur 23 a tendance à se décharger naturellement dans le transformateur 3. La décharge du condensateur 23 s'arrête au moment où la tension aux bornes dudit condensateur atteint la valeur de la tension Zener des diodes 21. Dans l'exemple illustré, le circuit 4 comporte des circuits de seuil pour pouvoir mémoriser les tensions appartenant aussi bien aux impulsions positives que négatives.

Sur la figure 4, on peut voir un second exemple de réalisation du circuit de commutation selon l'invention. Ce montage présente les particularités suivantes :
- il est normalement bloqué au repos et supporte toute la tension à commuter ;
- lorsqu'il est rendu conducteur par une impulsion de commande, il garde la mémoire de son état conducteur (à condition de ne pas dépasser son temps de conduction maximum) ;
- on peut le rebloquer par une impulsion de commande. Il reprend alors son état d'origine.

L'exemple illustré sur la figure 4 comporte cinq étages. L'entrée du commutateur 100 est reliée à deux lignes 6 et 7. La ligne 7 est connectée à l'entrée d'une diode 8 et d'un condensateur 10, ainsi qu'à la grille du transistor Q1. La ligne 6 est reliée à l'entrée d'une résistance 9 et à la source du transistor Q1. Les sorties de la résistance 9 du condensateur 10 et de la diode 8 sont reliées entre elles et reliées aux entrées de la diode 8, résistance 9 et condensateur 10 des étages 5 suivants. Le drain du transistor Q1 est relié à la source du transistor Q2. Les sorties de la diode 8 de la résistance 9 et du condensateur 10 du premier étage sont reliées à la grille du transistor Q2.

Avantageusement, entre la source et le drain de chaque transistor Q1 à Q5 est placée une diode 41. La sortie du cinquième étage du dispositif selon l'invention est reliée au point A porté à un potentiel positif V+. La ligne d'entrée 6 du commutateur 100 est reliée au point que l'on veut porter au potentiel V+.

La valeur des condensateurs 10 suit une progression arithmétique en partant des étages d'ordre le plus élevé vers les étages d'ordre le moins élevé. La raison de la suite est égale à la charge parasite grille-source des transistors Q utilisés. En effet, le condensateur 10 appartenant au premier étage du commutateur 100 devra pouvoir charger le condensateur parasite grille-source de quatre transistors : Q2, Q3, Q4 et Q5. Par contre, par exemple le condensateur 10 du troisième étage 5 du commutateur 100 n'aura qu'à charger le condensateur parasite des transistors Q4 et Q5. La capacité du condensateur 10 du dernier étage est par exemple égale à 470 pF.

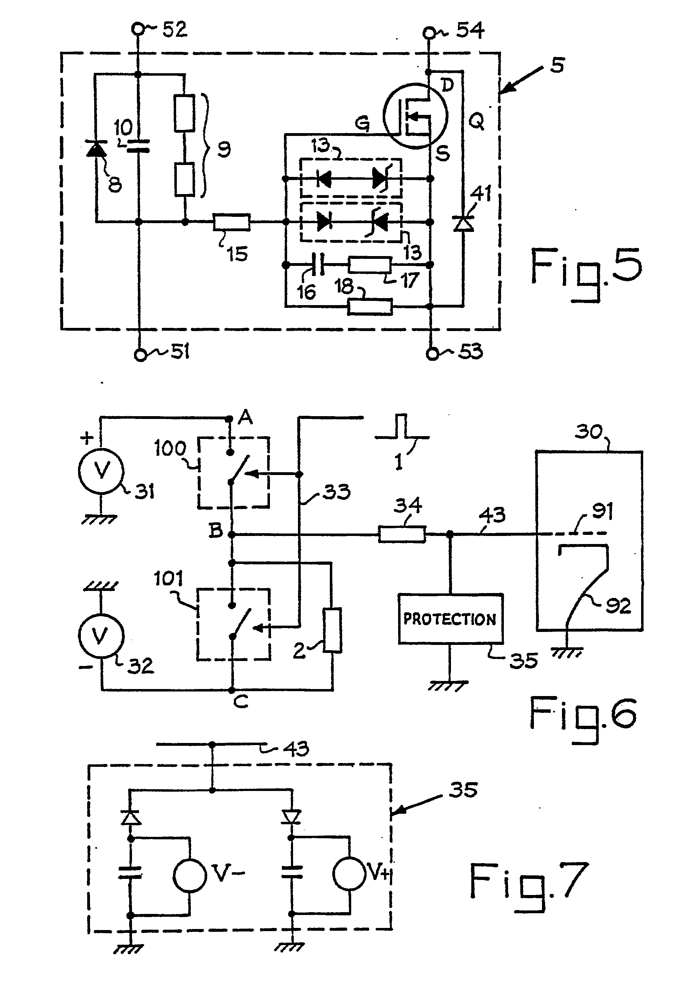

Sur la figure 5, on peut voir un étage du commutateur 100. Une première entrée 51 est reliée à l'entrée de la diode 8 du condensateur 10, des résistances 9 et de la résistance 15. Les sorties de la diode 8, du condensateur 10 et des résistances 9 sont reliées à la sortie 52 de l'étage 5. L'entrée 53 de l'étage 5 est reliée à l'entrée de la résistance 18, de la résistance 17, de la diode 41, de deux transils 13 et de la source du transistor Q. La sortie de la résistance 17 est reliée au condensateur 16. Les sorties de la résistance 18, du condensateur 16, de deux transils 13 sont reliées d'une part à la résistance 15 et d'autre part à la grille du transistor Q. La sortie de la diode 41 est reliée au drain du transistor Q. Le drain du transistor Q est relié à la sortie 54 de l'étage 5.

Les sorties 52 et 54 d'un étage 5 sont reliées respectivement aux entrées 51 et 53 de l'étage 5 suivant.

Sur la figure 6, on peut voir un dispositif de commutation de tension permettant la commande d'un tube électronique 30. Le tube 30 est un tube commandable par une grille 91. Le flux d'électrons émise par la cathode 92 est fonction de la tension appliquée à la grille 91. Les quantités d'énergie nécessaire pour porter la grille 91 à une tension élevée sont faibles.

Le dispositif de la figure 6 comporte un générateur de tension négative 32 relié en parallèle à une résistance de polarisation 2, et à un commutateur 101 illustré par la figure 1. D'autre part, le dispositif de la figure 6 comporte un générateur de tension positive 31 relié à un commutateur 100 de la figure 4. Les sorties des commutateurs 100 et 101 sont reliées à un point B. Le point B est relié à travers une résistance 34 et une ligne 43 à la grille 91. Les impulsions de commande 1 sont transmises aux commutateurs 100 et 101 à travers une ligne 33 et au travers d'un transformateur 3 non représenté. Avantageusement, les commutateurs 100 et 101 sont reliés à un transformateur unique comportant deux circuits secondaires. Avantageusement, un circuit 4 de mémorisation unique est relié aux deux commutateurs 100 et 101. Avantageusement, le dispositif comporte les moyens de protection 35 reliant la ligne 43 de commande de la ligne 91 à la masse en cas d'établissement d'arcs électriques à l'intérieur du tube 30. Dans un premier exemple de réalisation, les moyens de protection 35 comportent un éclateur. Ce dispositif de protection a l'inconvénient de se comporter comme un court-circuit tant qu'il n'a pas été désamorcé. Avantageusement, on utilise comme moyen de protection 35 limiteur. Un tel dispositif est illustré sur la figure 7.

Au repos les commutateurs 100 et 101 sont ouverts, la grille est portée à la tension V- par l'intermédiaire de la résistance de polarisation 2, la tension (V+) - (V-) est supportée par le commutateur 100. La tension de commande du commutateur 100 est égale à zéro. Tous les transistors sont bloqués et se répartissent la tension V+ - V- en fonction des rapports potentiométriques du pont de résistance 11. La tension de commande du commutateur 101 est égale à zéro, tous les transistors Q sont bloqués mais la tension à leur bord est maintenue à zéro grâce à la résistance de polarisation 2. La différence de potentiel entre le point B et le point C du circuit est quasiment nulle.

A l'établissement de la commande du faisceau, le point B est porté au potentiel V+. Le commutateur 100 est fermé tandis que le commutateur 101 est ouvert. La grille est portée au potentiel V+ à travers la résistance de protection R1 de faible valeur. La tension (V+) - (V-) est supportée par le commutateur 101. A ce moment là la tension de commande du commutateur 101 est égale à -10 V. Le transistor Q1 est maintenu bloqué par la tension de commande. Le point B passe à la tension V+. La série de réseaux RC se comporte comme un pont diviseur équilibré et assure l'étagement de tension grille des transistors MOS. Les transistors agissent en fonction de leur tension grille-source, de manière à se répartir la différence des tensions entre les points B et C. La tension de commande du commutateur 100 est égale à + 10 V. Le transistor Q1 devient conducteur et provoque la décharge du condensateur 10 du premier étage en direction de la grille du transitor Q2 qui entre à son tour en conduction. Le phénomène de mise en conduction se propage ainsi jusqu'au transistor Q5. Les diodes 41 permettent de renforcer localement une commande de grilles insuffisantes.

En commande blocage de faisceaux, le commutateur 100 est ouvert tandis que le commutateur 101 est fermé. La grille 91 est portée à un potentiel V- par l'intermédiaire de la résistance de protection R1. Au bout de quelques microsecondes, le commutateur 101 repasse automatiquement en position ouverte de façon à remmener le commutateur des grilles 91 à l'état de repos initial. La tension de commande du commutateur est égale à + 10 V, le transistor Q1 devient conducteur et provoque la décharge de son condensateur 10 dans la grille du transistor Q2. Le transistor Q2 devient à son tour conducteur et provoque la mise en conduction de Q3, le phénomène se propage jusqu'à ce que les transistors soient devenus conducteurs. La tension de commande du commutateur 100 est égale à - 10 V. Le point B est porté à la tension V-. Le transistor Q1 se bloque sous l'effet de la tension de commande et provoque le reblocage de toute la chaîne des transistors Q2 à Q5.

La tension au maximal commutée à un dispositif selon l'invention, est égale au produit du nombre de transistors par la tension maximale supportée par un transistor. Le nombre de transistors est limité par le retard accumulé d'un transistor au transistor suivant lors des phases de changement d'état. A partir de sept transistors IRF 420 le retard cummulé provoque des surtensions dégradant fortement les performances de l'ensemble.

Pour le fonctionnement haute fréquence on peut utiliser un dispositif de commutation utilisant deux commutateurs 100 illustrés par la figure 4. Par contre on n'arrive pas à commander un radar fonctionnant en continu (fréquence de répétition 0 Hz).

Un premier exemple de réalisation du dispositif selon l'invention comportant des commutateurs 100 et 101 comportant chacun cinq transistors, l'amplitude en tension de commande des grilles était réglable entre 0 et 2400 V, la largeur d'impulsion était variable entre 0,8 µs et 40 µs, la fréquence de récurrence pouvant varier entre 0 et 50 kHz. Le temps de montée sur une charge de 200 pF était égal à 100 ns. Pour un dispositif comportant des commutateurs 100 et 101 comprenant chacun six transistors la tension maximale obtenue en continu était égale à 2800 V.

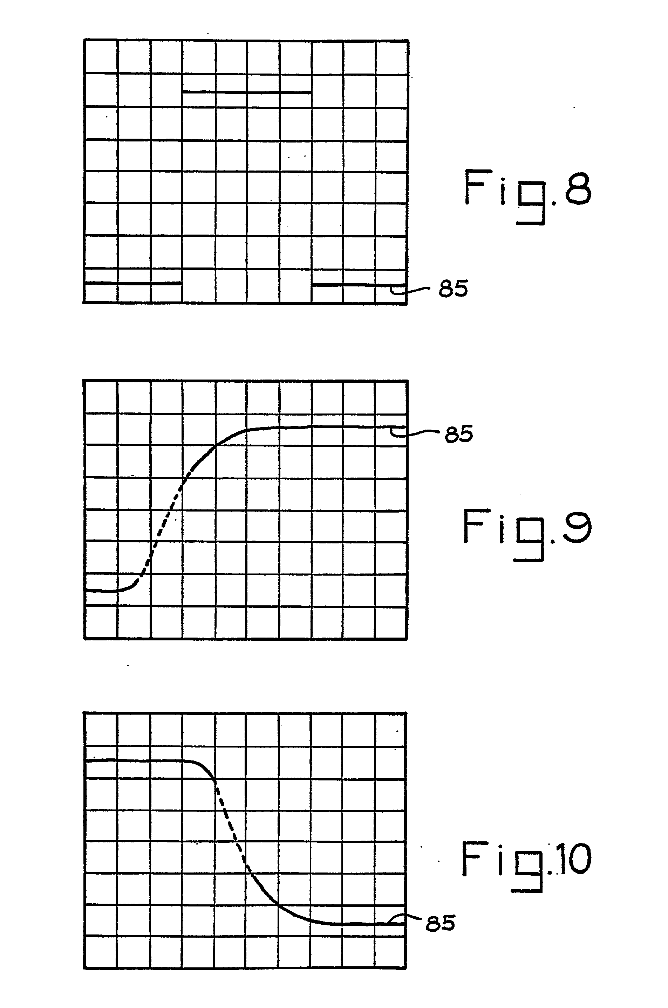

Les figures 8 à 16 illustrent les performances du dispositif selon l'invention. Elles sont la copie d'écran d'oscilloscope visualisant la réponse d'une tension en fonction du temps.

Sur la figure 8, on peut voir une courbe 85 illustrant une fonction v = f(t), l'évolution de la tension avec le temps. La courbe de la figure 8 correspond à des commutateurs 100 et 101 comportant chacun six transistors commutant des tensions de + 1000 V à - 800 V sur une grille de capacité 250 pF. L'échelle de la figure 8 correspond à 500 V par division verticale et 1 µs par division horizontale.

Sur la figure 9, on peut voir une courbe 85 illustrant le temps de montée d'un commutateur à six transistors chargeant une grille de capacité 250 pF. Sur la figure 9, une division horizontale correspond à 50 ns.

Sur la figure 10, est illustré par une courbe 85 le temps de descente du dispositif selon l'invention utilisé pour l'établissement des figures 8 et 9.

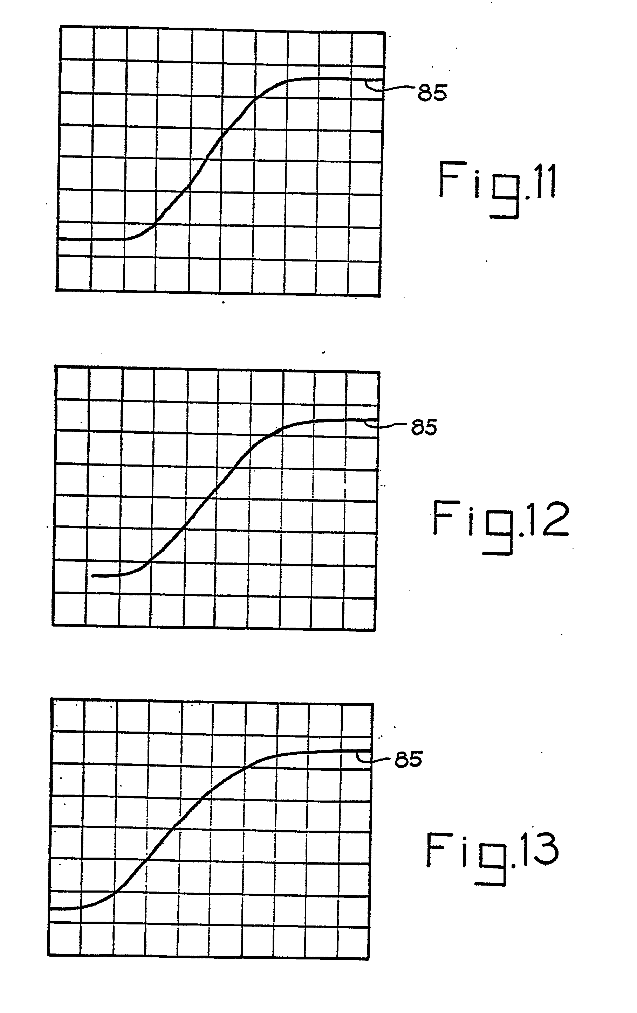

Les figures 11 à 16 illustrent la stabilité en température du dispositif selon l'invention. Pour ces figures on a utilisé des commutateurs 100 et/ou 101 à cinq transistors commutant une différence de tension de 2000 V sur une grille de capacité 150 pF. Une division horizontale correspond à 20 ns.

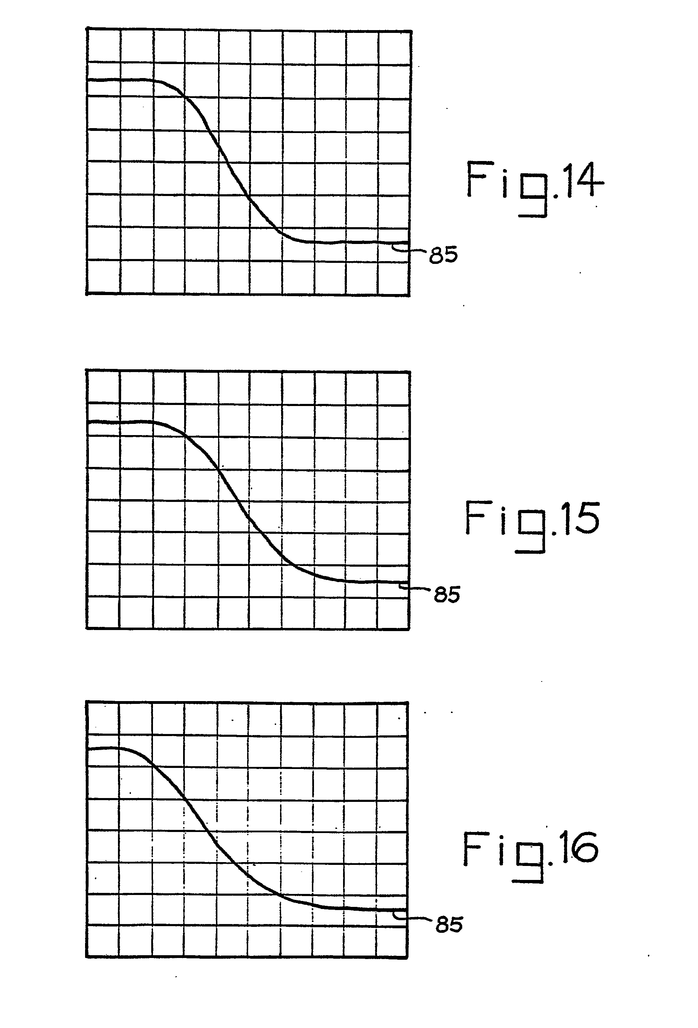

La courbe 85 des figures 11 et 14 respectivement illustrent le temps de montée et le temps de descente à la température de 233 K.

La courbe 85 des figures 12 et 15 illustre respectivement le temps de montée et le temps de descente à la température de 300 K.

La courbe 85 des figures 13 et 16 illustre le temps de montée et de descente à la température de 353 K.

L'invention s'applique principalement à la commutation de tubes électroniques commandables par grille notamment pour application radars et télécommunications.

**Revendications**

1. Elément (5) modulaire de commutation de tension comportant une première entrée (51) et une première sortie (52) connectées en parallèle à travers une résistance (9), un condensateur (10), une seconde entrée (53) reliée à la source d'un transistor (Q) à effet de champ à grille isolée (MOS) de puissance, une seconde sortie (54) reliée au drain dudit transistor (Q), ladite première entrée (51) étant reliée à la grille dudit transistor (Q), caractérisé par le fait qu'il comporte une diode (8) dont le pôle doppé positivement est relié à la première entrée (51) et le pôle doppé négativement est relié à la première sortie (52).

2. Elément (5) modulaire de commutation de tension selon la revendication 1, caractérisé par le fait qu'il comporte une résistance (11) mise en série avec le condensateur (10) entre la première entrée (51) et la première sortie (52).

3. Elément (5) de commutation de tension selon la revendication 2, caractérisé par le fait qu'il comporte une diode (12) dont le pôle doppé négativement est relié à la connexion du condensateur (10) et de la résistance (11) mise en série et le pôle doppé positivement à la première sortie (52).

4. Elément (5) de commutation de tension selon la revendication 1, 2 ou 3, caractérisé par le fait qu'il comporte une résistance de faible valeur (15) placée entre la grille du transistor (Q) et la première entrée (51).

5. Elément (5) de commutation de tension selon la revendication 1, 2, 3 ou 4, caractérisé par le fait qu'il comporte placés en parallèle entre la grille et la source du transistor (Q) deux transils (13) de polarisations opposées, une résistance (18), une résistance (17) placée en série avec un condensateur (16).

6. Elément (5) de commutation de tension, selon la revendication 2, 3, 4 ou 5, caractérisé par le fait que la source et le drain du transistor (Q) sont reliés par une diode (41) polarisée en directe.

7. Dispositif de commutation de tension, caractérisé par le fait qu'il comporte au moins deux éléments (5) de commutation selon l'une quelconque des revendications 1 à 5, les premières (52) et les secondes (54) sorties d'un élément (5) de commutation étant connectées respectivement aux premières (51) et secondes (53) entrées de l'élément (5) de commutation suivant.

8. Dispositif selon la revendication 7, caractérisé par le fait que la capacité des condensateurs (10) suit une progression arithmétique de raison égale à la valeur des capacités parasites grille-source des transistors (Q).

9. Dispositif selon la revendication 7, caractérisé par le fait que la valeur des résistances (11) mise en série avec un condensateur (10) entre les premières entrées (51) et les premières sorties (52) diminue pour chaque élément (5) de commutation connecté en série, de façon à compenser la consommation d'électricité des transistors (Q).

10. Dispositif selon la revendication 6, 8 ou 9, caractérisé par le fait qu'il comporte des moyens (4) de mémorisation de tension électrique comprenant un condensateur (23) susceptible d'être chargé à travers une diode (19) mise tête-bêche avec une diode Zener (21).

11. Dispositif selon la revendication 10, caractérisé par le fait qu'un condensateur (22) est connecté aux bornes de la diode Zener (21) permettant de transmettre les impulsions.

12. Dispositif selon la revendication 10 ou 11, caractérisé par le fait que les moyens (4) de mémorisation de tension électrique comportent deux ensembles de polarisation opposées de diode (19, 20), une diode Zener (21) permettant de mémoriser les tensions négatives et les tensions positives.

13. Dispositif de commande de tube électronique (30) permettant d'appliquer une tension électrique sur la grille (91) dudit tube électronique (30), caractérisé par le fait qu'il comporte un générateur (31) de tension positive, un générateur (32) de tension tension négative, reliés chacun par dispositif de commutation (100, 101) selon l'une quelconque des revendications 7 à 12 à un point B relié à un point B relié à ladite grille (91).

14. Dispositif selon la revendication 13, caractérisé par le fait qu'il comporte une résistance (2) de polarisation connectée en parallèle à un dispositif (101) de commutation relié au générateur (32) de tension négatives et que le point B est relié à la grille (91) à travers une résistance (34) de protection.

15. Dispositif selon la revendication 13 ou 14, caractérisé par le fait qu'il comporte des moyens de protection (35) du dispositif et du tube électronique (30) en cas d'établissement d'arc électrique à l'intérieur du tube électronique (30).

16. Dispositif selon la revendication 15, caractérisé par le fait que le moyen de protection (35) est un limiteur de tension.

## Claims

1. A modular voltage switching element (5) comprising a first input (51) and a second output (52) connected via a parallel arrangement of resistor (9) and a capacitor (10), a second input (53) connected to an insulated gate field effect (MOS) power transistor (Q), a second output (54) connected to the drain of said transistor (Q), said first input (51) being connected to the gate of said transistor (Q), characterized in that the element comprises a diode (8) whose positively doped pole is connected to the first input (51) and whose negatively doped pole is connected to the first output (52).

2. A modular voltage switching element (5) according to claim 1, characterized in that it comprises a resistor (11) connected in series with the capacitor (10) between the first input (51) and the first output (52).

3. A voltage switching element (5) according to claim 2, characterized in that it comprises a diode (12), whose negatively doped pole is connected to the connection of the capacitor (10) and to the series connected resistor (11), and whose positively doped pole is connected to the first output (52).

4. A voltage switching element (5) according to claim 1, 2 or 3, characterized in that it comprises a low value resistor (15) disposed between the gate of the transistor (Q) and the first input (51).

5. A voltage switching element (5) according to claim 1, 2, 3 or 4, characterized in that it comprises parallelly disposed between the gate and the source of the transistor (Q) two oppositely biassed transils (13), a resistor (18) and a series arrangement of a resistor (17) and a capacitor (16).

6. A voltage switching element (5) according to claim 3, 4 or 5, characterized in that the source and the drain of the transistor (Q) are interconnected by a diode (41) biassed in forward direction.

7. A voltage switching device, characterized in that it comprises at least two switching elements according to any one of the claims 1 to 5, with the first (52) and the second output (54) of one switching element (5) being connected respectively to the first (51) and second input (53) of the following switching element (5).

8. A device according to claim 7, characterized in that the capacitance of the capacitors (10) develops along an arithmetical progression in correspondence with the value of the parasitic gate-to-source capacitances of the transistors (Q).

9. A device according to claim 7, characterized in that the value of the resistors (11) connected in series with a capacitor (10) between the first inputs (51) and the first outputs (52) decreases from one to the next-following series connected switching element (5), so as to compensate for the electricity consumption of the transistors.

10. A device according to claim 6, 8 or 9, characterized in that it comprises means (4) for storing an electric voltage, these means comprising a capacitor (23) susceptible of being charged via a diode (19) antiparallelly connected to a Z-diode (21).

11. A device according to claim 10, characterized in that a capacitor (22) is connected to the terminals of the Z-diode (21) and adapted to allow the transmission of the pulses.

12. A device according to claim 10 or 11, characterized in that the means (4) for storing an electric voltage comprise two oppositely biassed assemblies of diodes (19, 20), a Z-diode (21) being adapted to store the negative and the positive voltages.

13. A device for controlling an electronic tube (30) permitting the application of an electric voltage to the grid (91) of said electronic tube (30), characterized in that the device comprises a positive voltage generator (31), a negative voltage generator (32), each being connected by a switching device (100, 101) according to any one of claims 7 through 12 to a point B which in turn is connected to said grid (91).

14. A device according to claim 13, characterized in that it comprises a biassing resistor (2) connected in parallel to a switching device (101) which in turn is connected to the negative voltages generator (32), and in that the point B is connected to the grid (91) via a protection resistor (34).

15. A device according to claim 13 or 14, characterized in that it comprises means (35) for protecting the device and the electronic tube (30) in the event of formation of an electric arc inside the electronic tube (30).

16. A device according to claim 15, characterized in that the protection means (35) is a voltage limiter.

## Patentansprüche

1. Modulares Spannungsschaltelement (5) mit einem ersten Eingang (51) und einem ersten Ausgang (52), die über die Parallelschaltung eines Widerstands (9) und eines Kondensators (10) verbunden sind, einem zweiten Eingang (53), der an die Source eines Leistungstransistors (Q) vom Feldeffekttyp (MOS) mit isoliertem Gate (MOS) angeschlossen ist, und einem zweiten Ausgang (54), der mit dem Drain dieses Transistors (Q) verbunden ist, wobei der erste Eingang (51) an das Gate des Transistors (Q) angeschlossen ist, dadurch gekennzeichnet, daß das modulare Spannungsschaltelement eine Diode (8) aufweist, deren positiv dotierter Pol an den ersten Eingang (51) und deren negativ dotierter Pol an den ersten Ausgang (52) angeschlossen ist.

2. Spannungsschaltelement (5) nach Anspruch 1, dadurch gekennzeichnet, daß es einen Widerstand (11) aufweist, der mit dem Kondensator (10) in Reihe zwischen den ersten Eingang (51) und den ersten Ausgang (52) geschaltet ist.

3. Spannungsschaltelement (5) nach Anspruch 2, dadurch gekennzeichnet, daß es eine Diode (12) aufweist, deren negativ dotierter Pol mit dem Verbindungspunkt zwischen dem Kondensator (10) und dem damit in Reihe geschalteten Widerstand (11), und deren positiv dotierter Pol mit dem ersten Ausgang (52) verbunden ist.

4. Spannungsschaltelement (5) nach Anspruch 1, 2 oder 3, dadurch gekennzeichnet, daß es einen kleinen Widerstand (15) zwischen dem Gate des Transistors (Q) und dem ersten Eingang (51) besitzt.

5. Spannungsschaltelement (5) nach Anspruch 1, 2, 3 oder 4, dadurch gekennzeichnet, daß es in Parallelschaltung zwischen dem Gate und der Source des Transistors (Q) geschaltete Transils (13) entgegengesetzter Polarität, einen Widerstand (18) und einen mit einem Kondensator (16) in Reihe geschalteten Widerstand (17) aufweist.

6. Spannungsschaltelement (5) nach Anspruch 2, 3, 4 oder 5, dadurch gekennzeichnet, daß die Source und der Drain des Transistors (Q) über eine in Vorwärtsrichtung polarisierte Diode (41) verbunden sind.

7. Spannungsschaltvorrichtung, dadurch gekennzeichnet, daß sie mindestens zwei Schaltelemente (5) nach einem beliebigen der Ansprüche 1 bis 5 aufweist, wobei die ersten (52) und die zweiten Ausgänge (54) eines Schaltelements (5) mit dem ersten (51) bzw. dem zweiten Eingang (53) des folgenden Schaltelements (5) verbunden sind.

8. Spannungsschaltvorrichtung nach Anspruch 7, dadurch gekennzeichnet, daß die Kapazität der Kondensatoren (10) in einer arithmetischen Progression entsprechend dem Wert der Störkapazitäten zwischen Gate und Source der Transistoren (Q) gewählt ist.

9. Spannungsschaltvorrichtung nach Anspruch 7, dadurch gekennzeichnet, daß der Wert der mit einem Kondensator (10) zwischen den ersten Eingängen (51) und den zweiten Ausgängen (52) in Reihe geschalteten Widerstände (11) bei jedem in Reihe geschalteten Schaltelement (5) abnimmt, derart, daß der Stromverbrauch der Transistoren (Q) kompensiert wird.

10. Spannungsschaltvorrichtung nach Anspruch 6, 8 oder 9, dadurch gekennzeichnet, daß sie Mittel (4) zum Speichern der elektrischen Spannung aufweist, die einen Kondensator (23) enthalten, der über eine zu einer Zenerdiode (21) antiparallel geschaltete Diode (19) aufgeladen werden kann.

11. Spannungsschaltvorrichtung nach Anspruch 10, dadurch gekennzeichnet, daß ein Kondensator (22) an die Klemmen der Zenerdiode (21) zur Übertragung der Impulse angeschlossen ist.

12. Spannungsschaltvorrichtung nach Anspruch 10 oder 11, dadurch gekennzeichnet, daß die Mittel (4) zum Speichern der elektrischen Spannung zwei Diodengruppen (19, 20) entgegengesetzter Polarität aufweisen, wobei eine Zenerdiode (21) die Speicherung der negativen und der positiven Spannungen ermöglicht.

13. Steuervorrichtung für eine Elektronenröhre (30), die das Anlegen einer elektrischen Spannung an das Gitter (91) der Elektronenröhre ermöglicht, dadurch gekennzeichnet, daß die Vorrichtung einen Generator (31) positiver Spannung und einen Generator (32) negativer Spannung aufweist, die je über eine Schaltvorrichtung (100, 101) gemäß einem beliebigen der Ansprüche 7 bis 12 an einen Punkt B angeschlossen ist, der mit dem genannten Gitter (91) verbunden ist.

14. Vorrichtung nach Anspruch 13, dadurch gekennzeichnet, daß sie einen Vorspannungswiderstand (2) aufweist, der parallel an eine mit dem Generator (32) negativer Spannungen verbundenen Schaltvorrichtung (101) angeschlossen ist, und daß der Punkt B über einen Schutzwiderstand (34) mit dem Gitter (91) verbunden ist.

15. Vorrichtung nach Anspruch 13 oder 14, dadurch gekennzeichnet, daß sie Mittel (35) zum Schutz der Vorrichtung und der Elektronenröhre (30) für den Fall der Entstehung eines elektrischen Lichtbogens im Inneren der Elektronenröhre (30) aufweist.

16. Vorrichtung nach Anspruch 15, dadurch gekennzeichnet, daß das Schutzmittel (35) ein Spannungsbegrenzer ist.

Fig.1

Fig.2

Fig.3

Fig.4

Fig.5

Fig.6

Fig.7

Fig.8

85

Fig.9

85

Fig.10

85

Fig.11

85

Fig.12

85

Fig.13

85

Fig.14

85

Fig.15

85

Fig.16

85